(19) Europäisches Patentamt / European Patent Office / Office européen des brevets

(11) **EP 4 465 468 A1**

(12) **EUROPEAN PATENT APPLICATION**

(43) Date of publication:
**20.11.2024 Bulletin 2024/47**

(21) Application number: **23208489.7**

(22) Date of filing: **08.11.2023**

(51) International Patent Classification (IPC):
**H02J 1/10** $^{(2006.01)}$      **H02J 3/38** $^{(2006.01)}$
**H02S 50/10** $^{(2014.01)}$

(52) Cooperative Patent Classification (CPC):
**H02J 1/102; H02J 3/381; H02S 50/10;**
H02J 2300/26

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **17.05.2023 CN 202310569402**

(71) Applicant: **Sungrow Power Supply Co., Ltd.
Hefei, Anhui 230088 (CN)**

(72) Inventors:
• **YANG, Zongjun
Hefei 230088 (CN)**
• **LI, Xiaoxun
Hefei 230088 (CN)**
• **LIU, Yu
Hefei 230088 (CN)**

(74) Representative: **Rooney, John-Paul
Withers & Rogers LLP
2 London Bridge
London SE1 9RA (GB)**

(54) **IV CURVE SCANNING METHOD AND DEVICE FOR MULTI-INPUT CONVERTER**

(57) An IV curve scanning method and an IV curve scanning device for a multi-input converter are provided. For each of input converters in the multi-input converter, a starting scanning voltage, a starting scanning moment, and scanning voltages at respective target scanning points are so determined based on a preset starting voltage, a minimum voltage and a preset number of the target scanning points that at each of the target scanning points there is at least one of the input converters whose scanning voltage is greater than a target voltage. The IV curve scanning for the input converter is performed based on the starting scanning voltage, the starting scanning moment, and the scanning voltages at respective target scanning points.

Determine a starting scanning voltage, a starting scanning moment and scanning voltages at respective target scanning points based on a preset starting voltage, a minimum voltage and a preset number of the target scanning points, where at each of the target scanning points, the scanning voltage for at least one of input converters is greater than a target voltage   S501

Perform IV curve scanning based on the starting scanning voltage, the starting scanning moment and the scanning voltages at the respective target scanning points   S502

**Figure 5**

## Description

### FIELD

The present disclosure relates to the technical field of electronics, and in particular to a current-voltage (IV) curve scanning method and an IV curve scanning device for a multi-input converter.

### BACKGROUND

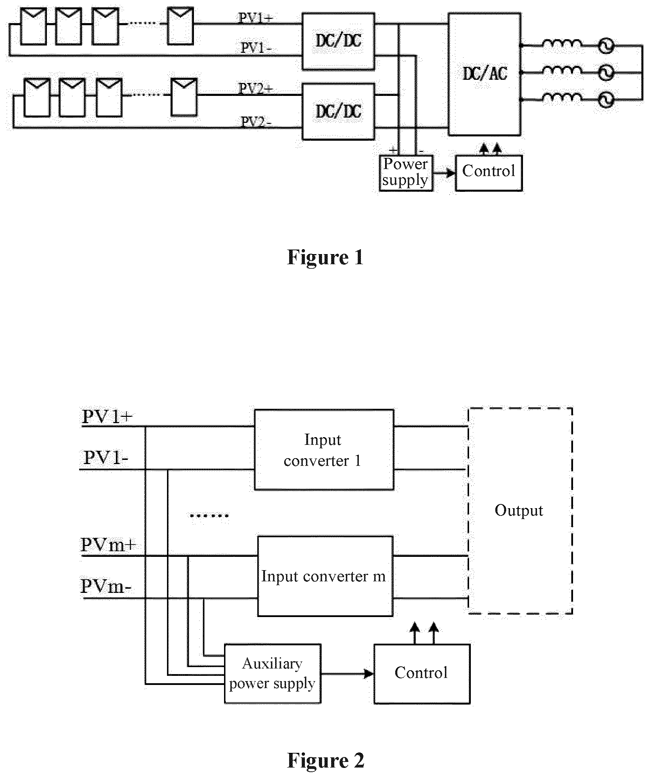

With the rapid development of the photovoltaic (PV) industry, the IV curve scanning at a module level has caught increasing attention. Currently, the conventional string inverter performs the IV curve scanning at the string level. Specifically, as shown in Figure 1, an upstream boost circuit supplies a tracking voltage in a range and data such as the voltage and the current of a PV string is acquired accordingly, and the corresponding IV curve is drawn based on the acquired voltage and current, so that the IV curve scanning is performed.

However, for the module-level power electronics (MLPE), e.g., a module-level multi-input converter is supplied with the PV input, and therefore the IV curve scanning at the module level is affected by a PV input voltage. The voltage supplied to the module-level multi-input converter is insufficient when the PV input voltage is too low, and consequently the IV curve scanning ends prematurely, resulting in an incomplete IV curve.

### SUMMARY

In view of this, an IV curve scanning method and an IV curve scanning device for a multi-input converter are provided according to the present disclosure, to solve the existing problem of incomplete IV curve due to premature end of the IV curve scanning that is resulted from excessively low PV input voltage.

In order to solve the above problem, the following technical solutions are provided according to the present disclosure.

In a first aspect, an IV curve scanning method for a multi-input converter is provided according to the present disclosure. The IV curve scanning method includes: for each of input converters in the multi-input converter: determining a starting scanning voltage, a starting scanning moment and scanning voltages at respective target scanning points based on a preset starting voltage, a minimum voltage and a preset number of the target scanning points, where at each of the target scanning points, the scanning voltage for at least one of the input converters is greater than a target voltage; and performing the IV curve scanning based on the starting scanning voltage, the starting scanning moment and the scanning voltages at the respective target scanning points.

In an embodiment, the determining the starting scanning voltage, the starting scanning moment and the scanning voltages at the respective target scanning points based on the preset starting voltage, the minimum voltage and the preset number of the target scanning points includes: determining a voltage interval based on the preset starting voltage, the minimum voltage, and the preset number of the target scanning points; and determining the starting scanning voltage, the starting scanning moment and the scanning voltages at the respective target scanning points based on a preset time interval and the voltage interval.

In an embodiment, the determining the voltage interval based on the preset starting voltage, the minimum voltage, and the preset number of the target scanning points includes: calculating a difference between the preset starting voltage and the minimum voltage; and calculating the voltage interval based on the preset number of the target scanning points and the difference.

In an embodiment, the determining the starting scanning voltage, the starting scanning moment and the scanning voltages at the respective target scanning points based on the preset time interval and the voltage interval includes: determining the starting scanning voltage and the starting scanning moment based on the preset time interval; and determining the scanning voltages at the respective target scanning points based on the voltage interval.

In an embodiment, the preset time interval is less than a duration of the IV curve scanning for each of input converters.

In an embodiment, the preset time interval is greater than or equal to a duration of the IV curve scanning for each of input converters.

In an embodiment, the method further includes: determining the target scanning points, where the voltage intervals for all the input converters in the multi-input converter are equal; dividing all the input converters in the multi-input converter into at least one first input converter and at least one second input converter; for each of the at least one first input converter, determining the scanning voltages at the target scanning points from the preset starting voltage to the minimum voltage at the voltage intervals; and for each of the at least one second input converter, determining the scanning voltages at the target scanning points from the minimum voltage to the preset starting voltage at the voltage intervals.

In an embodiment, the method further includes: acquiring data comprising voltages and currents at the respective target scanning points and drawing an IV curve based on the acquired data after the performing the IV curve scanning.

In a second aspect, an IV curve scanning device is provided according to the present disclosure. The IV curve scanning device includes a multi-input converter, an auxiliary power supply, and a controller. The multi-input converter includes M input converters, M is greater than or equal to 2, and the multi-input converter is connected to the auxiliary power supply. The auxiliary power supply is connected to the controller. The controller is configured to perform the IV curve scanning method according to the first aspect of the present disclosure.

In an embodiment, for each of the M input converters, a positive input of the input converter is connected to a positive terminal of the auxiliary power supply via a diode, wherein the positive input terminal of the input converter is arranged at a photovoltaic (PV) side; and a negative terminal of the input converter is connected to a negative terminal of the auxiliary power supply.

In an embodiment, the multi-input converter is a flyback converter. The positive input of the input converter is connected to an anode of the diode, a cathode of the diode is connected to the positive terminal of the auxiliary power supply, and the negative terminal of the input converter is connected to the negative terminal of the auxiliary power supply.

In an embodiment, the multi-input converter is an H-bridge dual active bridge (DAB) converter.

The IV curve scanning method and device for a multi-input converter are provided according to the present disclosure. The starting scanning voltage, the starting scanning moment, and scanning voltages at respective target scanning points are so determined for each of the input converters in the multi-input converter based on the preset starting voltage, the minimum voltage and the preset number of the target scanning points that at each of the target scanning points there is at least one of the input converters whose scanning voltage is greater than a target voltage. The IV curve scanning is performed based on the starting scanning voltage, the starting scanning moment, and the scanning voltages at the respective target scanning points. According to the technical solutions of the present disclosure, the starting scanning voltage, the starting scanning moment, and scanning voltages at respective target scanning points are so determined for each of the input converters by the controller based on the preset starting voltage, the minimum voltage, the preset number of the target scanning points that at each of the target scanning points there is at least one of the input converters whose scanning voltage is greater than the target voltage. Therefore, the IV curve scanning at the module level is not affected by the PV input voltage, thereby deepening the IV curve scanning. Accordingly, a complete IV curve can be obtained.

**BRIEF DESCRIPTION OF THE DRAWINGS**

In order to more clearly illustrate technical solutions in embodiments of the present disclosure or in the conventional technology, the drawings to be used in the description of the embodiments or the conventional technology are briefly described below. Apparently, the drawings in the following description show only some embodiments of the present disclosure, and other drawings may be obtained by those skilled in the art from the drawings without any creative work.

Figure 1 is a schematic structural diagram illustrating a string converter according to the conventional technology;

Figure 2 is a schematic structural diagram illustrating an IV curve scanning device for a multi-input converter according to an embodiment of the present disclosure;

Figure 3 is a schematic structural diagram illustrating a dual flyback converter according to an embodiment of the present disclosure;

Figure 4 is a schematic structural diagram illustrating an H-bridge dual active bridge (DAB) converter according to an embodiment of the present disclosure;

Figure 5 is a schematic flow chart illustrating an IV curve scanning method for a multi-input converter according to an embodiment of the present disclosure;

Figure 6 is a schematic diagram illustrating an IV curve acquired by a conventional MLPE performing the IV curve scanning at a module level;

Figure 7 is a schematic diagram illustrating respective voltage sequences of M input converters according to an embodiment of the present disclosure;

Figure 8 is a schematic diagram illustrating respective voltage sequences of two input converters according to an embodiment of the present disclosure;

Figure 9 is a schematic diagram illustrating IV curve scanning for one input converter before the IV curve scanning for another input converter according to an embodiment of the present disclosure;

Figure 10 is a schematic diagram illustrating starts on IV curve scanning for three input converters are staggered according to an embodiment of the present disclosure; and

Figure 11 is a schematic diagram illustrating simultaneous IV curve scanning for two input converters according to another embodiment of the present disclosure.

**DETAILED DESCRIPTION**

The technical solutions in the embodiments of the present disclosure are described clearly and completely hereinafter with reference to the drawings in the embodiments of the present disclosure. Apparently, the described embodiments are some rather than all of the embodiments of the present disclosure. All of other embodiments obtained by those skilled in the art based on the embodiments in the present disclosure without any creative work fall within the protection scope of the present disclosure.

The terms "include", "comprise" or any other variants thereof are intended to be non-exclusive. Therefore, a process, method, article or device including a series of elements include not only these elements but also other elements that are not clearly enumerated, or further include elements inherent in the process, method, article or device. Unless expressively limited, the statement **"including a..." does not exclude the case that other** similar elements may exist in the process, method, article or device including the series of elements.

An IV curve scanning device for a multi-input converter is provided according to an embodiment of the present disclosure. As shown in Figure 2, the IV curve scanning device includes the multi-input converter, an auxiliary power supply, and a controller. The multi-input converter includes M input converters, where M is greater than or equal to 2. In Figure 2, the auxiliary power supply is shown as "power supply" and the controller is shown as "control".

The multi-input converter is connected to the auxiliary power supply.

In an embodiment, for each of the M input converters, a positive input of the input converter is connected to a positive terminal of the auxiliary power supply via a diode, a negative terminal of the input converter is connected to a negative terminal of the auxiliary power supply, and the positive input of the input converter is arranged at a photovoltaic side.

It should be noted that the positive inputs of the input converters in the multi-input converter are connected to the positive terminal of the auxiliary power supply through respective diodes, so that the input converters are connected in parallel to the auxiliary power supply. Therefore, each of the input converters can supply power to the auxiliary power supply.

In practice, the input converter in the multi-input converter may be a buck converter, a boost converter, or a buck-boost converter, and the multi-input converter outputs direct-current power. The auxiliary power supply is powered by the multi-input converter. All the input converters output currents to an input end of the auxiliary power supply via respective diodes.

In an embodiment, the multi-input converter is a flyback converter. For each of the input converters, the positive input terminal of the input converter is connected to an anode of the diode, a cathode of the diode is connected to the positive terminal of the auxiliary power supply, and the negative input terminal of the input converter is connected to the negative terminal of the auxiliary power supply.

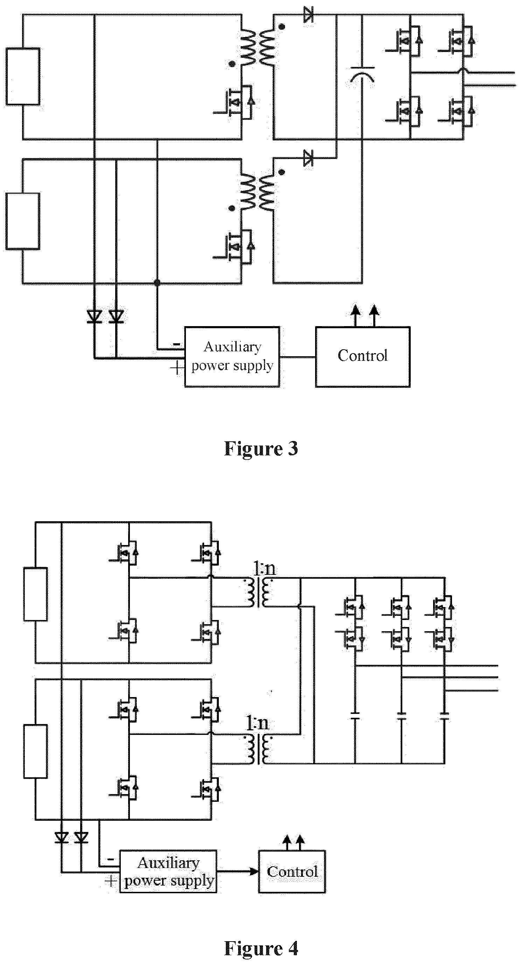

For example, as shown in Figure 3, the multi-input converter includes two flyback input converters. For each of the input converters, the positive input of the input converter is connected to the anode of the diode, the cathode of the diode is connected to the positive terminal of the auxiliary power supply, and the negative terminal of the input converter is connected to the negative terminal of the auxiliary power supply.

nal of the auxiliary power supply.

It should be noted that the flyback converter includes two flyback input converters, and the flyback input converters output alternating-current power. Since the flyback input converter and a primary side of the auxiliary power supply are grounded, the positive terminal of the auxiliary power supply may be directly powered through the cathode of the diode.

The auxiliary power supply is connected to the controller. The controller is configured to perform the IV curve scanning method.

In an embodiment, as shown in Figure 4, the multi-input converter is an H-bridge DAB converter, that is, the flyback converter is the H-bridge DAB converter.

In the embodiment of the present disclosure, each of the input converters is connected to output sides of photovoltaic modules.

It should be noted that the output sides of the photovoltaic modules may be cascaded through an upstream converter, connected in parallel, or connected to a downstream converter, depending on actual applications, and are not limited in the present disclosure.

The auxiliary power supply is connected to the controller. The controller is configured to perform the IV curve scanning method.

The IV curve scanning device for the multi-input converter is provided according to the present disclosure. The multi-input converter is connected to the auxiliary power supply. The auxiliary power supply is connected to the controller. The starting scanning voltage, the starting scanning moment, and scanning voltages at respective target scanning points are so determined for each of the input converters in the multi-input converter by the controller based on a preset starting voltage, a minimum voltage and a preset number of the target scanning points that at each of the target scanning points there is at least one of the input converters whose scanning voltage is greater than a target voltage. The IV curve scanning is performed based on the starting scanning voltage, the starting scanning moment, and the scanning voltages at the respective target scanning points. According to the technical solutions of the present disclosure, the starting scanning voltage, the starting scanning moment, and scanning voltages at respective target scanning points are so determined for each of the input converters by the controller based on the preset starting voltage, the minimum voltage, the preset number of the target scanning points that at each of the target scanning points there is at least one of the input converters whose scanning voltage is greater than the target voltage. Therefore, the IV curve scanning at the module level is not affected by the PV input voltage, thereby deepening the IV curve scanning. Accordingly, a complete IV curve can be obtained.

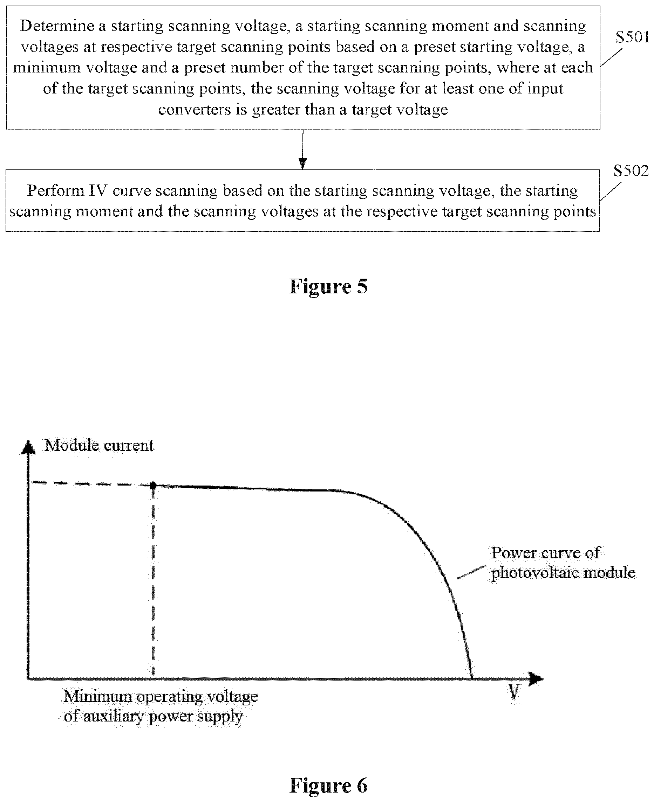

Based on the IV curve scanning device, an IV curve scanning method for the multi-input converter is further provided according to an embodiment of the present disclosure. As shown in Figure 5, the IV curve scanning method includes the following steps S501 to S502.

In step S501, a starting scanning voltage, a starting scanning moment, and scanning voltages at respective target scanning points are so determined for each of the input converters in the multi-input converter based on a preset starting voltage, a minimum voltage, a preset number of the target scanning points that at each of the target scanning points there is at least one of the input converters whose scanning voltage is greater than the target voltage.

In the embodiment of the present disclosure, the input converter performs the IV curve scanning on the corresponding photovoltaic module from the preset starting voltage Voc to 0V Therefore, the preset number of the target scanning points may be preset. The target scanning point is a point at which the input converter is to perform the IV curve scanning.

It should be noted that the preset starting voltage may be equal to an open circuit voltage of the photovoltaic module, or the preset starting voltage may be less than the open circuit voltage of the photovoltaic module and greater than the minimum voltage of the photovoltaic module, depending on actual applications, and which is not limited in the embodiments of the present disclosure.

For example, the open circuit voltage of a photovoltaic module is 50V The preset starting voltage may be set to 50V or 48V. Correspondingly, the preset number of the target scanning points may be set to 50 or 22. The preset starting voltage and the preset number of the target scanning points depend on actual applications, and are not limited in the embodiments of the present disclosure.

In an embodiment, after the preset number of the target scanning points is set, a voltage interval is determined based on the preset starting voltage, the minimum voltage, and the preset number of the target scanning points. The starting scanning voltage, the starting scanning moment, and the scanning voltages at the respective target scanning points are so determined based on a preset time interval and the voltage interval that at each of the target scanning points there is at least one of the input converters whose scanning voltage is greater than the target voltage.

It should be noted that the target voltage is a minimum operating voltage of the auxiliary power supply. The auxiliary power supply is directly powered by the input converters. As a result, the IV curve scanning cannot be performed once a voltage outputted by the input converter decreases to be less than the minimum operating voltage of the auxiliary power supply. In such case, an effective scanning voltage starts from the target voltage to the open circuit voltage inclusive, as shown in Figure 6. It can be seen from Figure 6 that an IV curve obtained by the conventional MLPE device performing the IV curve scanning is relatively narrow.

It should further be noted that the target voltage may be 20V, depending on actual applications, which is not limited in the embodiments of the present disclosure.

In a preferred embodiment of the present disclosure, a difference between the preset starting voltage and the minimum voltage for the input converter is calculated. The voltage interval for the input converter is calculated based on the preset number of the target scanning points and the difference. The voltage interval is calculated from the following equation (1)

$$\Delta V = \frac{Voc_i - V\min_i}{N} \qquad (1)$$

$\Delta V$ represents the voltage interval, $Voc_i$ represents a preset starting voltage for an i-th input converter in the multi-input converter, $V\min_i$ represents a minimum voltage for the i-th input converter, and N represents the preset number of the target scanning points.

For example, the preset number of the target scanning points is 22, the preset starting voltage is 50V, and the minimum voltage is 6V The difference between the preset starting voltage and the minimum voltage is calculated as 44V. A quotient obtained by dividing this difference by the preset number of the target scanning points is 2V, that is, the voltage interval is 2V

In a preferred embodiment of the present disclosure, the starting scanning voltage and the starting scanning moment for the input converter are determined based on the preset time interval. The scanning voltages at the respective target scanning points are determined based on the voltage interval.

In the embodiment, the preset time interval is determined based on durations of the IV curve scanning for the respective input converters.

In a preferred embodiment of the present disclosure, the preset time interval is less than each of the durations of the IV curve scanning for all the respective input converters, so as to stagger the IV curve scanning for the input converters.

In another preferred embodiment of the present disclosure, the preset time interval is not less than each of the durations of the IV curve scanning for all the respective input converters, so that the IV curve scanning for one input converter starts after the IV curve scanning for another input converter.

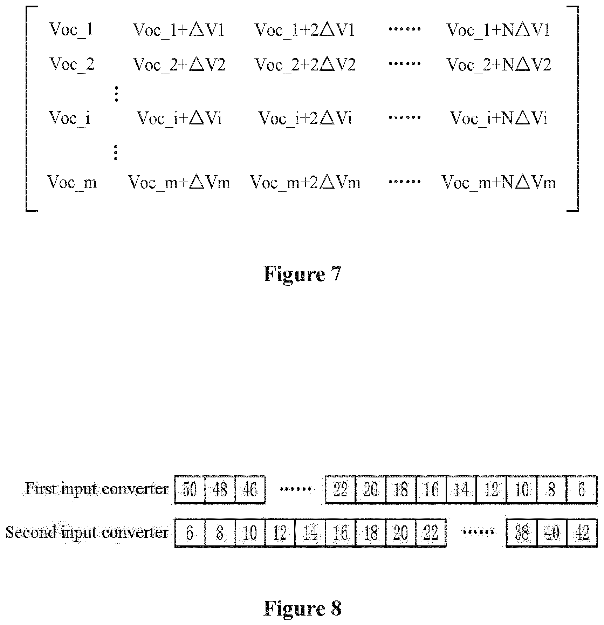

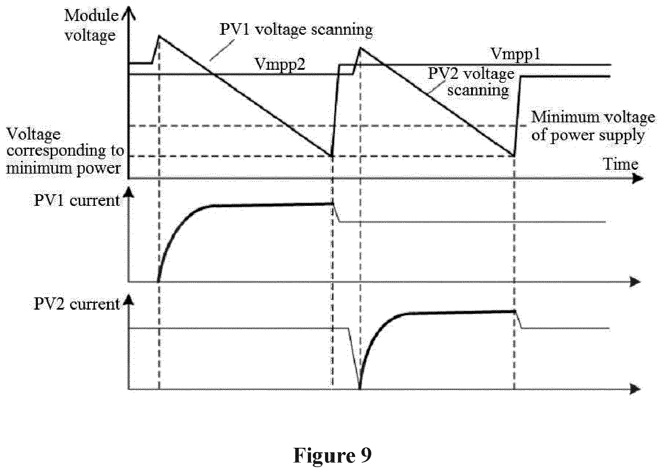

For example, the multi-input converter includes two input converters, and the preset time interval is set to be not less than each of the durations of the IV curve scanning for the two input converters. The starting scanning voltages and the starting scanning moments are determined for the two input converters based on the preset time interval. The scanning voltages at the respective target scanning points are determined based on the voltage interval, as shown in Figure 8. It can be seen from Figure 9 that during a first period, the IV curve scanning for a PV1 is performed, and a PV2 remains in a maximum power point tracking (MPPT) mode. During a second period, the IV curve scanning for the PV2 is performed, and the PV1 remains in the MPPT mode.

It should be noted that voltage Voc or Vmppt in other periods than the first or second period is added.

For another example, the multi-input converter includes three input converters, and the preset time interval is set to be less than each of the durations of the IV curve scanning for the three input converters. The starting scanning voltages and the starting scanning moments are determined for the three input converters based on the preset time interval. The scanning voltages at the respective target scanning points are determined based on the voltage interval, as shown in Figure 7.

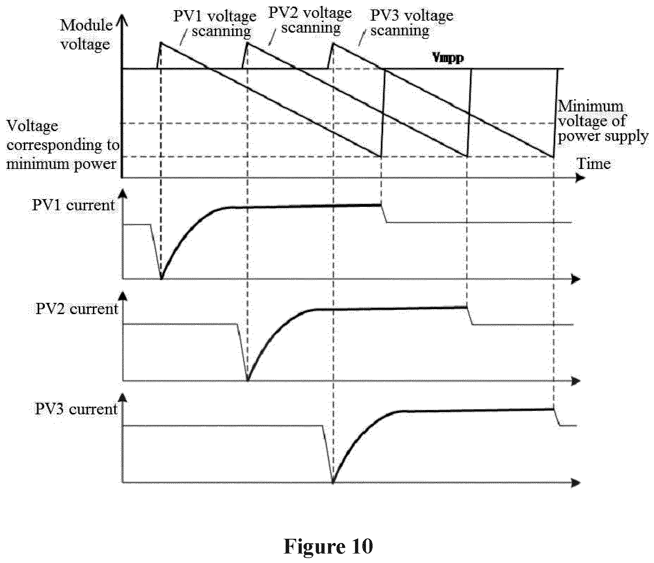

It can be seen from Figure 10 that the IV curve scanning for the three input converters are staggered, so that the power supplied to the auxiliary power supply is stable even if the input converter outputs a low voltage, thereby widening the IV curve scanning.

In the embodiment of the present disclosure, it is determined whether voltage intervals for the respective input converters are equal after the voltage intervals are determined and before the starting scanning voltage, the starting scanning moment, and the scanning voltages at the respective target scanning point are determined.

In a case that the voltage intervals for the respective input converters are equal, the starting scanning voltage, the starting scanning moment, and the scanning voltages at the respective target scanning point are determined based on the voltage interval and a trend in the voltage, so that the power supply is stable at each of the target scanning points, thereby protecting the power supply against the impact resulted from the IV curve scanning, and further widening the IV curve scanning at the module level.

In an embodiment, the starting scanning voltage, the starting scanning moment, and the scanning voltages at the respective target scanning point are determined as follows.

Multiple target scanning points are determined. The input converters in the multi-input converter is divided into at least one first input converter and at least one second input converter. For the first input converter, the scanning voltages at the respective target scanning points are set from the preset starting voltage to the minimum voltage at the corresponding voltage intervals, and the starting scanning moment and the starting scanning voltage are determined based on the preset starting voltage. For the second input converter, the scanning voltages at the respective target scanning points are set from the minimum voltage to the preset starting voltage at the corresponding voltage intervals, and the starting scanning moment and the starting scanning voltage are determined based on the minimum voltage.

For example, for each of m input converters, a preset starting voltage and a minimum voltage are determined. The voltage interval is calculated based on a preset number N of target scanning points, the preset starting voltage, and the minimum voltage. The 1st to (m-1)-th input converters are determined as the first input converter, the scanning voltages at the respective target scanning points are set from the preset starting voltage Voc to the minimum voltage Vmin at the corresponding voltage intervals, and the starting scanning moment and the starting scanning voltage are determined based on the preset starting voltage. The m-th input converter is determined as the second input converter, the scanning voltages at the respective target scanning points are set from the minimum voltage Vmin to the preset starting voltage Voc at the corresponding voltage intervals, and the starting scanning moment and the starting scanning voltage are determined based on the minimum voltage. In this way, the voltage sequences for the respective input converters are acquired, as shown in Figure 7. The voltage sequence includes the scanning voltages at the respective target scanning points.

For example, the multi-input converter includes two input converters, that is, a first input converter and a second input converter. For the first input converter, the preset starting voltage Voc is 50V, the minimum voltage Vmin is 6V, and the preset number of target scanning points is 22. For the second input converter, the preset starting voltage Voc is 42V, the minimum voltage Vmin is 6V, and the preset number of target scanning points is 18.

For the first input converter, the voltage interval is determined as 2V based on the preset starting voltage, the minimum voltage, and the preset number of target scanning points. For the second input converter, the voltage interval is determined as 2V based on the preset starting voltage, the minimum voltage, and the preset number of target scanning points.

For the first input converter, the scanning voltages at the respective target scanning points are set from the preset starting voltage to the minimum voltage at the voltage intervals, and the starting scanning moment and the starting scanning voltage are determined based on the preset starting voltage. For the second input converter, the scanning voltages at the respective target scanning points are set from the minimum voltage to the preset starting voltage at the voltage intervals, and the starting scanning moment and the starting scanning voltage are determined based on the minimum voltage. The voltage sequences for the first and second input converters are shown in Figure 8. The starting scanning voltage for the first input converter is 50V, and the starting scanning voltage for the second input converter is 6V.

It should be noted that from Figure 8, it can be seen that the starting scanning moment for the second input converter may set to a time instant when a fourth target scanning point for the first input converter is reached, depending on actual applications, which is not limited in the embodiments of the present disclosure.

It can be seen from Figure 8 that at each of the target scanning points there is at least one input converter whose scanning voltage is greater than 20V (that is, the target voltage), so that the auxiliary power supply is not interrupted due to under-voltage. Further, the IV curve scanning for each of the input converters can be performed with the voltage ranging from a minimum of 6V, having a wider range than the existing solution in which the voltage ranging from a minimum of 20V

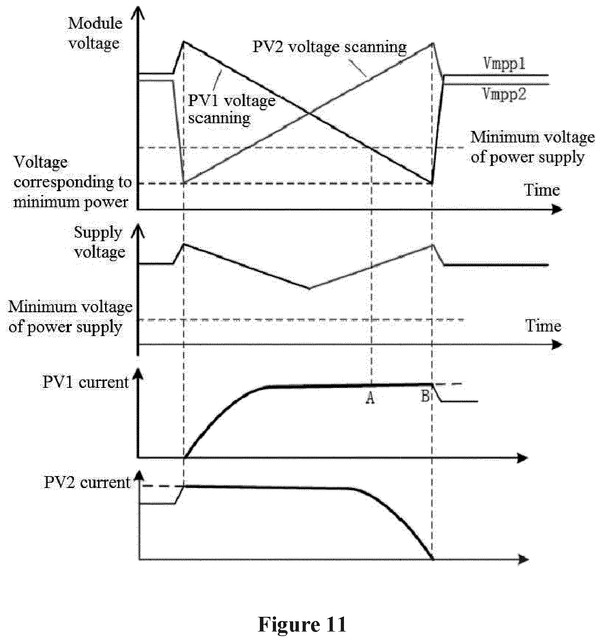

In practice, as shown in Figure 11, the IV curve scanning for the first input converter is performed based on the voltage sequence in a descending order, and the IV curve scanning for the second input converter is performed based on the voltage sequence in an ascending order. It can be seen from Figure 11 that at each of the target scanning points, a voltage supplied to the auxiliary power supply is greater than the minimum operating voltage of the auxiliary power supply, thereby preventing the controller form interrupting the IV curve resulted from shutdown of the auxiliary power supply due to under voltage.

In step S502, the IV curve scanning is performed for each of the input converters based on the starting scanning voltage, the starting scanning moment, and the scanning voltages at the respective target scanning points.

In step S502, for each of the input converters, after the starting scanning voltage, the starting scanning moment and the scanning voltages at the respective target scanning points are set, the IV curve scanning is performed from the starting scanning voltage and the starting scanning moment at the respective target scanning points sequentially. In this way, the IV curve scanning for the multi-input converter is performed.

Furthermore, in the embodiments of the present disclosure, the data include the voltage and the current data are acquired after the IV curve scanning for the multi-input converter is performed. The data includes voltages and currents at the respective target scanning points for each of the input converters, and the IV curve corresponding to the input converter is draw based on the voltages and the currents at the respective target scanning points.

The IV curve scanning method for the multi-input converter is provided according to the present disclosure. For each of the input converters in the multi-input converter, the starting scanning voltage, the starting scanning moment and the scanning voltages at the respective target scanning points are determined based on the voltage interval, or the starting scanning voltage and the starting scanning moment are determined based on the preset time interval, so that at each of the target scanning points there is at least one of the input converters whose scanning voltage is greater than the target voltage. Therefore, the IV curve scanning at the module level is prevented from being affected by the PV input voltage, thereby deepening the IV curve scanning. Further, the complete IV curve can be obtained.

The same or similar parts among the embodiments in this specification may be referred to each other, and each of the embodiments emphasizes differences from other embodiments. In particular, since the system or the embodiment of the system are similar to the embodiment of the method, the description or the embodiment of the system is relatively simple, and for relevant matters references may be made to the description of the embodiment of the method. The foregoing system and the embodiment of the system are only illustrative. Units described as separated components may be or may be not physically separated. Components shown as units may be or may be not physical units, i.e. the components may be located in one place or may be distributed among multiple network units. Some or all of the modules may be selected to implement the solutions of the embodiments of the present disclosure, depending on the actual requirements. Those skilled in the art can understand and implement the embodiments without any creative work.

It should further be appreciated by those skilled in the art that, units and algorithmic steps in the examples described according to the embodiments disclosed herein may be implemented by electronic hardware, computer software or a combination of the both. In order to illustrate the interchangeability between the hardware and the software clearly, the components and the steps in the examples are described generally according to functions in the above description. Whether the functions are implemented by hardware or software depends on specific applications and design constraints. For each specific application, those skilled in the art may implement the described functions in various manners, and none of which is considered to depart from the scope of the present disclosure.

Based on the above description of the disclosed embodiments, the features described in the different embodiments in this specification may be replaced or combined with each other, so that those skilled in the art can implement or use the present disclosure. Various modifications made to these embodiments may be apparent to those skilled in the art, and the general principle defined herein may be implemented in other embodiments without departing from the spirit or scope of the present disclosure. Therefore, the present disclosure is not limited to the embodiments described herein but conforms to a widest scope in accordance with principles and novel features disclosed in the present disclosure.

**Claims**

1. A current-voltage, IV, curve scanning method for a multi-input converter, comprising:
   for each of input converters in the multi-input converter:

   determining a starting scanning voltage, a starting scanning moment and scanning voltages at respective target scanning points based on a preset starting voltage, a minimum voltage and a preset number of the target scanning points, wherein at each of the target scanning points, the scanning voltage for at least one of the input converters is greater than a target voltage; and performing the IV curve scanning based on the starting scanning voltage, the starting scanning moment and the scanning voltages at the respective target scanning points.

2. The method according to claim 1, wherein the determining the starting scanning voltage, the starting scanning moment and the scanning voltages at the respective target scanning points based on the preset starting voltage, the minimum voltage and the preset number of the target scanning points comprises:

   determining a voltage interval based on the preset starting voltage, the minimum voltage, and the preset number of the target scanning points; and
   determining the starting scanning voltage, the starting scanning moment and the scanning voltages at the respective target scanning points based on a preset time interval and the voltage interval.

3. The method according to claim 2, wherein the determining the voltage interval based on the preset starting voltage, the minimum voltage, and the preset number of the target scanning points comprises:

   calculating a difference between the preset starting voltage and the minimum voltage; and
   calculating the voltage interval based on the preset number of the target scanning points and the difference.

4. The method according to claim 2, wherein the determining the starting scanning voltage, the starting scanning moment and the scanning voltages at the respective target scanning points based on the preset time interval and the voltage interval comprises:

   determining the starting scanning voltage and the starting scanning moment based on the preset time interval; and
   determining the scanning voltages at the respective target scanning points based on the voltage interval.

5. The method according to claim 2, wherein the preset time interval is less than a duration of the IV curve scanning for each of input converters.

6. The method according to claim 2, wherein the preset time interval is not less than a duration of the IV curve scanning for each of input converters.

7. The method according to claim 2, further comprising:

determining the target scanning points, wherein voltage intervals for all the input converters in the multi-input converter are equal;
dividing all the input converters in the multi-input converter into at least one first input converter and at least one second input converter;
for each of the at least one first input converter, determining the scanning voltages at the target scanning points from the preset starting voltage to the minimum voltage at the voltage intervals; and
for each of the at least one second input converter, determining the scanning voltages at the target scanning points from the minimum voltage to the preset starting voltage at the voltage intervals.

8. The method according to claim 1, further comprising: acquiring data comprising voltages and currents at the respective target scanning points and drawing an IV curve based on the acquired data after the performing the IV curve scanning.

9. An IV curve scanning device, comprising:

   a multi-input converter;
   an auxiliary power supply; and
   a controller, wherein
   the multi-input converter comprises M input converters and is connected to the auxiliary power supply, wherein M is greater than or equal to 2;
   the auxiliary power supply is connected to the controller; and
   the controller is configured to perform the method according to any one of claims 1 to 8.

10. The IV curve scanning device according to claim 9, wherein for each of the M input converters,

    a positive input of the input converter is connected to a positive terminal of the auxiliary power supply via a diode, wherein the positive input terminal of the input converter is arranged at a photovoltaic, PV, side; and
    a negative terminal of the input converter is connected to a negative terminal of the auxiliary power supply.

11. The IV curve scanning device according to claim 10, wherein the multi-input converter is a flyback converter, wherein
the positive input of the input converter is connected to an anode of the diode, a cathode of the diode is connected to the positive terminal of the auxiliary power supply, and the negative terminal of the input converter is connected to the negative terminal of the auxiliary power supply.

**12.** The IV curve scanning device according to claim 10, wherein the multi-input converter is an H-bridge dual active bridge, DAB, converter.

**Figure 1**

**Figure 2**

Figure 3

Figure 4

Determine a starting scanning voltage, a starting scanning moment and scanning voltages at respective target scanning points based on a preset starting voltage, a minimum voltage and a preset number of the target scanning points, where at each of the target scanning points, the scanning voltage for at least one of input converters is greater than a target voltage

S501

Perform IV curve scanning based on the starting scanning voltage, the starting scanning moment and the scanning voltages at the respective target scanning points

S502

**Figure 5**

Module current

Power curve of photovoltaic module

Minimum operating voltage of auxiliary power supply

V

**Figure 6**

$$\begin{bmatrix} \text{Voc\_1} & \text{Voc\_1}+\triangle\text{V1} & \text{Voc\_1}+2\triangle\text{V1} & \cdots\cdots & \text{Voc\_1}+\text{N}\triangle\text{V1} \\ \text{Voc\_2} & \text{Voc\_2}+\triangle\text{V2} & \text{Voc\_2}+2\triangle\text{V2} & \cdots\cdots & \text{Voc\_2}+\text{N}\triangle\text{V2} \\ & \vdots & & & \\ \text{Voc\_i} & \text{Voc\_i}+\triangle\text{Vi} & \text{Voc\_i}+2\triangle\text{Vi} & \cdots\cdots & \text{Voc\_i}+\text{N}\triangle\text{Vi} \\ & \vdots & & & \\ \text{Voc\_m} & \text{Voc\_m}+\triangle\text{Vm} & \text{Voc\_m}+2\triangle\text{Vm} & \cdots\cdots & \text{Voc\_m}+\text{N}\triangle\text{Vm} \end{bmatrix}$$

**Figure 7**

| First input converter | 50 | 48 | 46 | ······ | 22 | 20 | 18 | 16 | 14 | 12 | 10 | 8 | 6 |
|---|---|---|---|---|---|---|---|---|---|---|---|---|---|

| Second input converter | 6 | 8 | 10 | 12 | 14 | 16 | 18 | 20 | 22 | ······ | 38 | 40 | 42 |
|---|---|---|---|---|---|---|---|---|---|---|---|---|---|

**Figure 8**

**Figure 9**

**Figure 10**

Figure 11

Europäisches
Patentamt

European
Patent Office

Office européen
des brevets

# EUROPEAN SEARCH REPORT

Application Number

EP 23 20 8489

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | AU 2020 353 609 A1 (HUAWEI DIGITAL POWER TECHNOLOGIES CO LTD [CN]) 26 August 2021 (2021-08-26) | 1,8-12 | INV. H02J1/10 H02J3/38 H02S50/10 |
| A | * claim 1; figures 1-9 * | 2-7 | |
| X | VINNIKOV DMITRI ET AL: "Implementation of Global Maximum Power Point Tracking in Photovoltaic Microconverters: A Survey of Challenges and Opportunities", IEEE JOURNAL OF EMERGING AND SELECTED TOPICS IN POWER ELECTRONICS, IEEE, PISCATAWAY, NJ, USA, vol. 11, no. 2, 21 December 2021 (2021-12-21), pages 2259-2280, XP011937789, ISSN: 2168-6777, DOI: 10.1109/JESTPE.2021.3137521 [retrieved on 2021-12-22] | 1,8-12 | |
| A | * the whole document * | 2-7 | |
| X | AU 2020 439 859 A1 (HUAWEI DIGITAL POWER TECHNOLOGIES CO LTD [CN]) 21 July 2022 (2022-07-21) | 1,8-12 | TECHNICAL FIELDS SEARCHED (IPC) |
| A | * figures 1-8 * | 2-7 | H02J H02S |

The present search report has been drawn up for all claims

| Place of search | Date of completion of the search | Examiner |
|---|---|---|
| Munich | 4 June 2024 | Bourdon, Jérémy |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 23 20 8489

This annex lists the patent family members relating to the patent documents cited in the above-mentioned European search report.
The members are as contained in the European Patent Office EDP file on
The European Patent Office is in no way liable for these particulars which are merely given for the purpose of information.

04-06-2024

| Patent document cited in search report | | Publication date | Patent family member(s) | | Publication date |
|---|---|---|---|---|---|
| AU 2020353609 | A1 | 26-08-2021 | AU 2020353609 | A1 | 26-08-2021 |
| | | | CN 110677118 | A | 10-01-2020 |
| | | | EP 3907882 | A1 | 10-11-2021 |
| | | | ES 2961247 | T3 | 11-03-2024 |
| | | | JP 7301997 | B2 | 03-07-2023 |
| | | | JP 2022523238 | A | 21-04-2022 |
| | | | US 2021376790 | A1 | 02-12-2021 |
| | | | WO 2021057075 | A1 | 01-04-2021 |
| AU 2020439859 | A1 | 21-07-2022 | AU 2020439859 | A1 | 21-07-2022 |
| | | | CN 112703669 | A | 23-04-2021 |
| | | | CN 115498959 | A | 20-12-2022 |
| | | | EP 3926823 | A1 | 22-12-2021 |
| | | | EP 4258505 | A2 | 11-10-2023 |
| | | | ES 2961249 | T3 | 11-03-2024 |
| | | | JP 2023511565 | A | 20-03-2023 |
| | | | US 2022190605 | A1 | 16-06-2022 |
| | | | WO 2021195929 | A1 | 07-10-2021 |

EPO FORM P0459

For more details about this annex : see Official Journal of the European Patent Office, No. 12/82